# EUROPEAN PATENT APPLICATION

(11) **EP 0 561 016 A1**
(43) Date of publication of application: **22.09.1993**
(21) Application number: 92104574.6
(22) Date of filing: 17.03.1992
(51) Int. Cl.: C23C 14/06, C23C 14/24

(54) **Multilayer coating by vacuum vapor deposition**

(71) Applicant: Taira, Tetsusaburo, Tokorozawa-shi, Saitama (JP); Takano, Yasusaburo, Tokorozawa-shi, Saitama (JP)
(72) Inventor: Taira, Tetsusaburo, Tokorozawa-shi, Saitama (JP); Takano, Yasusaburo, Tokorozawa-shi, Saitama (JP)
(74) Representative: Bühling, Gerhard, Dipl.-Chem.

(57) **Abstract**

A process for vacuum vapor deposition, particularly the process for applying an organic protective layer to an inorganic material deposited on optical articles by using porous ceramic material in a vacuum vapor deposition apparatus equipped with both organic material vaporizing means and inorganic material vaporizing means therein.

According to the process of the present invention, organic protective layer can be easily applied quantatively to the deposited inorganic material. Any solvent and washing step before coating organic protective layer needed in the prior art can be completely eliminated.

## Description

### BACKGROUND OF THE INVENTION

### FIELD OF THE INVENTION

This invention relates to a process for vacuum vapor deposition, particulaly to a process for vacuum vapor deposition by coating an organic protective film on an inorganic material deposited on optical articles.

### PRIOR ART

As well known, boiling point of material depends on atmospheric pressure and evaporation of the material can be attained by lowering surrounding pressure. Thus, vacuum vapor deposition can be attained by depositing vapors on the surface of solid articles positioned in vapor flow in vacuum. Vapor deposition of inorganic materials on optical articles forms non-smoothed irregular surface of non-controlled optical characteristics, because of adhered irreegular crystals deposited on the surface. Thus spaces between the irregular crystals are filled with an organic film forming material to obtain flat and smooth surface of the articles of desired optical characteristics, thereby also obtaining a protecting film on the surface of the optical articles from accidental stain troubles by human hands, etc.

The organic protecting film can be prepared by dissolving organic materials to be coated in a solvent to obtain a solution and evaporating the solvent after coating.

However, a very dilute solution is to be used for obtaining a very thin organic film, requiring a large amount of solvent and the CFC type solvents used in the prior art are known as the ozone destroying compounds. Recently developed non-CFC-type solvents are also including fluorine or chlorine atoms to be inhibited in future.

Another problem in the prior art is the washing process. As well known, the protective coating process includes controlling of the concentration of the solution, coating of the solution and evaporating of the solvent. Every step is conducted after removing vapor deposited articles from vapor deposition apparatus. The fresh surface of the vapor deposited articles is covered by small crystalline particles deposited and very sensitive to dust materials in atomosphere. The floating dust materials by flowing of air or innert gas into the apparatus exposed to air are adhered to the surface, requiring further washing step before organic protective coating.

As illustrated above, environmental pollution by the solvent used and the surface washing process of the deposition product before coating organic material are important problems to be solved in the prior art.

Accordingly, the object of the present invention is to eliminate such disadvantages in the prior art and to provide a novel process for coating the organic film without using any solvent and any washing process.

### SUMMARY OF THE INVENTION

The present invention relates to a process for vacuum vapor deposition, particularly to a process for applying an organic protective layer to an inorganic material deposited on optical articles by means of ceramic porous material in an apparatus having both inorganic material vaporizing means and organic material vaporizing means, wherein an organic protective film can be easily obtained by heating the porous ceramic material impregnated with the organic protective film forming material.

According to the process of the present invention, coating of deposited inorganic material by organic protective film can be easily attained in a vacuum vapor deposition apparatus requiring no solvent and no washing process.

Thus, the washing step in the prior art before coating organic protective film can be eliminated. Also, the solvent for preparing the solution is not required.

By employing the porous ceramic material, the amount of organic protective film forming material can be easily controlled and controlled amount of the organic material can be applied to the articles to be coated by adjusting particle size of the porous ceramic material, viscosity of the solution to be absorbed, etc. Particularly, very small amount of the organic material can be supplied easily by using controlled amount of the organic material and controlled quantitative coating with the organic material can be easily attained without requiring any precise determination apparatus.

Further, according to the present invention, chemical vapor deposition can be also attained easily by polymerizing materials deposited on the articles to be coated, as well as physical vapor deposition.

### DESCRIPTION OF THE PREFERRED EMBODIMENTS

The following examples are presented for better understanding of the present invention to those skilled in the art. It is also to be understood that these examples are intended to be illustrative only and are not intended to limit the invention in any way.

### EXAMPLE 1

Fully dried 15x15x1 mm of porous ceramic plates were impregnated with polyethylene wax molten. The weight of the ceramic plate were increased by 0.20gr for respective plate.

One of the ceramic plate thus obtained was put in a vacuum vapor deposition apparatus having the radius of 600 mm and evaporated by heating to 85^{o}C, after vapor deposition of inorganic material. Determination of the film thus prepared by interferometer gave 0.03 µm of film thickness, satisfied thickness for use in a protective film.

### EXAMPLE 2

A solution of silicon resin compound was used for the organic film forming material, having 3% of residues by evaporation. Fully dried porous ceramic balls were impregnated with the silicon resin solutoin and then dried under evacuation to 10⁻⁶ torr, in a drier having solvent recovery means to remove vaporized materials. Thus, the weight of the ceramic ball were increased by 0.50gr.

Two of the ceramic balls thus prepared were put into a vacuum vapor depositing apparatus having the radius of 600mm and heated to 150°C after vacuum vapor deposition of inorganic material. Determination of the organic film thus obtained gave 0.08 µm of film thickness clearly satisfied thickness for use in a protecting film.

### EXAMPLE 3

Urethane monomer solution was used for the organic film forming material, having 25% residuals by evaporation.

Crushed porous ceramic particles were fully dried and impregnated with the monomer solution and then dried in a drier as in Example 2. The weight of the ceramic particles were increased from 1.0gr to 1.2gr, namely the increase by 20%. 2gr of the ceramic particles thus obtained were put in a vacuum vapor depositing apparatus having the radius of 600 mm and heated to 50°C after vacuum vapor deposition of inorganic mateial, under heating the articles to be coated at 150°C by means of another heater. Determination of the organic film thus obtained gave 0.05 µm of film thickness, clearly satisfied thickness for use in a protecting film.

A process for vacuum vapor deposition, particularly the process for applying an organic protective layer to an inorganic material deposited on optical articles by using porous ceramic material in a vacuum vapor deposition apparatus equipped with both organic material vaporizing means and inorganic material vaporizing means therein.

According to the process of the present invention, organic protective layer can be easily applied quantatively to the deposited inorganic material. Any solvent and washing step before coating organic protective layer needed in the prior art can be completely eliminated.

## Claims

1. A process for vacuum vapor deposition which comprises further depositing an organic protective material on an inorganic layer deposited on the articles in a vacuum vapor deposition apparatus equipped with both organic material vaporizing means and inorganic material vaporizing means.

2. A process according to Claim 1, wherein deposition of the organic protective layer is conducted by heating porous ceramic material impregnated with an organic film forming material in vacuum.

3. Porous ceramic materials impregnated with an organic film forming material for vaporizing in vacuum.
